# EUROPEAN PATENT APPLICATION

(11) **EP 4 471 440 A1**
(43) Date of publication of application: **04.12.2024**
(21) Application number: 23176291.5
(22) Date of filing: 31.05.2023
(51) Int. Cl.: G01R 31/34, G01R 23/16

(54) **ACHIEVING HIGH SPECTRAL RESOLUTION IN MACHINE DIAGNOSTICS BESIDE CHANGING SPEED**

(71) Applicant: Siemens Aktiengesellschaft, 80333 München (DE)
(72) Inventor: Ladanyi, Gabor, 2092 Budakeszi (HU); Nemet, Bence, 6133 Jászszentlászló (HU); Nyíri, Gábor, 1037 Budapest (HU)
(74) Representative: Siemens Patent Attorneys

(57) **Abstract**

Present invention concerns a method of analyzing a machine arrangement (100). The method comprises obtaining (A10) N time domain measurement samples at times T (n) pertaining to operation of the machine arrangement, with a typical frequency F of the operating machine arrangement, wherein n runs over the number of samples N and the distance between neighboring samples in time domain is T. The method also comprises determining (A12) updated time domain measurement samples based on adapting a timing T_{adapt}(n) of each sample based on the associated T (n) and T, further based on an actual frequency factual (n) of the analyzed machine arrangement (100) associated to the timing T (n) and/or Tadapt(n), and further based on f. It also comprises determining (A14) M normalized time domain measurement samples at times T(m) with a constant sampling period T2, wherein m runs over the number of samples M. Moreover, the method comprises performing (A16) frequency analysis on the normalized time domain measurement samples.

The invention also concerns associated devices.

## Description

Present invention concerns a method of analyzing a machine arrangement or its operation. The invention also concerns a corresponding computer program product, storage medium, electronic control device and a machine arrangement.

### Background of the Invention

In the course of machine diagnostics, FFT (Fast Fourier Transform) is a method to analyze time domain measurements, which may comprise a number of samples taken over time, for example at constant frequency and/or periodically with the same time domain gap between all samples. To perform a successful analysis in frequency domain, appropriate frequency resolution is needed, e.g., when the diagnostic method is vibrational or a motor current analysis. High resolution in frequency domain can be gained with a long-time measurement of the signal; during this measurement, the speed or the supply frequency of the motor should be constant. In cases in which the speed is not constant, for example, when the speed is controlled by a PID (proportional-integral-derivative) controller, high resolution spectral analysis can be performed, but the spectrum may be faded.

### Disclosure of the Invention

A problem underlying the invention consists in providing an improved technique to provide high-resolution frequency analysis for machine arrangements operated with varying speed.

The invention solves the given problem by means of subject-matter defined in enclosed independent claims. Dependent claims describe preferred embodiments.

There is disclosed a method of analyzing a machine arrangement and/or operation thereof; the method may be performed by an electronic control device and/or circuitry, in particular processing circuitry. The method comprises obtaining N time domain measurement samples at times T (n) pertaining to operation of the machine arrangement. The operating machine arrangement has a typical (also referred to as reference) frequency F, wherein n runs over the number of samples N and the distance between neighboring samples in time domain is T.

The method also comprises determining updated time domain measurement samples based on adapting a timing T_{adapt} (n) of each sample based on the associated T(n) and/or T, further based on an actual frequency f_{actual} (n) of the analyzed machine arrangement associated to the timing T(n) and/or T_{adapt}(n), and further based on F. Moreover, the method comprises determining M normalized time domain measurement samples at times T(m) with a constant sampling period T2, wherein m runs over the number of samples M. The method also comprises performing frequency analysis on the normalized time domain measurement samples. The method may comprise performing error analysis and/or controlling the machine arrangement based on the frequency analysis, e.g., increasing or decreasing speed, and/or performing a stop, and/or providing a warning indication, e.g., to an operator, which may be based on an error analysis or diagnosis.

The method may comprise an/or facilitate identifying, in the frequency analysis, irregular peaks in frequency domain with good resolution even if the operational speed of the machine arrangement changes, e.g., changes significantly over the time horizon of the frequency analysis.

It may be considered that the updated time domain measurement samples may be determined based on, and/or utilizing, T_{adapt}=T*f_{actual}/F. This may allow producing samples that have a quasi-reference shape, e.g., according to typical operation at frequency F. T_{adapt} may indicate the length of time between two neighboring samples of the updated samples (sampling interval); to calculate the sample position in time, sequential arrangement of the intervals may be considered, in particular considering T(n), e.g., for all n smaller than the current n. Different sampling interval T_{adapt} may have different durations, e.g., depending on the actual frequency using for adapting; The expression T_{adapt} (n) may be used to indicate the associated samples and/or different sampling intervals.

It may be considered that F lies in an operational range of frequencies of the machine arrangement. This may provide a suitable reference, in particular in system with essentially harmonic behavior. However, cases in which F may be outside an operational range may be considered, e. g., depending on waveform. The operational range may describe the range of frequencies at which the machine arrangement or component to be analyzed usually is operated and/or driven, and/or may be driven or operated.

In some cases, F may be 50Hz. The machine arrangement may be driven with AC current, which may have a frequency of 50Hz. This may represent a suitable reference for such systems.

The samples may indicate a current (e.g., amplitude and/or phase), and/or voltage, and/or speed (e.g., rotational speed), and/or vibrational amplitude. Such parameters may be suitable for frequency analysis; they may reflect erroneous and/or undesirable effects occurring during operation.

In general, M may be larger than N. M, N may be integer values larger than 1. M may be at least or equal to 1.2 times N, or at least or equal to 1.5 times N, or at least or equal to 2 times N. M may be dependent on the smallest and/or largest and/or average f_{actual} (n). The M samples may in general be based on estimation and/or interpolation of sample values for the M normalized time domain measurement samples, e.g., based on the measurement samples and/or their values obtained. This may provide equidistant samples (in time domain), e.g., for frequency analysis like in an FFT.

The method may be performed conditional on an acceleration threshold or speed change threshold being reached by the machine arrangement. If there is a small change in speed and/or acceleration (lower than the threshold), the frequency analysis may be performed on obtained time domain measurement samples, without determining adapted timing and/or normalized samples. This may lower processing requirements. The acceleration and/or speed change may be determined based on measurements, e.g., as provided by an inverter and/or rotational speed sensor and/or current sensor and/or other sensor, and/or determined based on the time domain measurement samples, and/or based on control signaling received, e.g., from circuitry controlling the speed or acceleration. The acceleration and/or speed change may pertain to a specific time interval and/or sample number, e.g., covering a FFT window, or parts thereof.

It may generally be considered that the machine arrangement may operate at varying or changing speed. The speed may be controlled by circuitry, e.g., a PID and/or electronic circuitry, e.g., according to a program and/or operator input. Frequency analysis with good resolution may be provided even in such cases. It may be considered that the machine arrangement is operated at different speeds and/or frequencies (e.g., next to and/or including F), e.g., scanning and/or analyzing frequency behavior over a speed and/or frequency range; this may be part of the method. Thus, difficult-to-detect effects may be detected, e.g., a presence of a resonance, for example at a border of an operational range.

The machine arrangement may comprise a rotational element like a rotor or motor or generator. Such elements may represent a component of the arrangement, and may be particularly for the proposed analysis due to their normally harmonic or quasi-harmonic operation.

In some variants, the machine arrangement may comprise an AC (Alternating Current) machine, and/or may be driven by three-phase current, wherein the samples may represent a current amplitude. In such cases, the current may be easy to measure, while being indicative of operational conditions of the driven component or motor or machine.

Performing frequency analysis may in general comprise performing Fast Fourier Transform of the normalized time domain measurement samples. Other forms of frequency domain transformation may be considered, e.g., other forms of Discrete Fourier Transforms. This may allow a reliable frequency domain representation, which may be highly indicative of operational behavior, in particular potential errors.

There is also considered a computer program product comprising program code causing processing circuitry and/or a computer to perform the method described herein. The computer and/or processing circuitry may represent, and/or be part of, an electronic control device.

Furthermore, a storage medium storing a computer program product as described herein is proposed. The storage medium may comprise and/or be implemented as one or more memories and/or have different parts or components of the program product stored on different memories or media. The storage medium may be non-transitory.

An electronic control device comprising processing circuitry is described. The electronic control device is adapted to perform a method as described herein. In particular, the processing circuitry may be adapted to perform one or more actions of the method and/or the method. The device and/or circuitry may comprise one or more components and/or may be a distributed, e.g., interconnected via suitable communication interfaces. Different components may perform different actions, e.g., based on exchanging information via the interface/s. The electronic control device may be and/or comprise one or more computers and/or controllers and/or processing circuitries.

A machine arrangement comprising an electronic control device as described herein is also disclosed. The machine arrangement may be controlled and/or monitored (e.g., based on performing frequency analysis) by the electronic control device.

In general, the duration of an interval in time domain between two samples may be considered a sampling interval or sampling period, which may be referenced as T. The N time domain measurement samples may be sampled with constant sampling period T and/or may be sampled periodically, and/or with a sampling frequency f_{T}. In general, there may be one fewer interval than samples for each group of measurement samples.

Obtaining measurement samples may comprise performing measurements and/or receiving measurement information and/or the samples, e.g., from one or more sensors and/or sensor arrangements and/or measurement devices. A frequency may correspond to representation or parametrization of a frequency (e.g., rotational or vibrational frequency) and/or speed, e.g., rotational speed or a velocity).

A typical frequency or reference frequency may be dependent on a waveform occurring during operation of the machine arrangement (e.g., used to drive operation), and/or a frequency range of operation, and/or operational conditions of the machine arrangement. It may be a frequency most commonly or typically occurring during operation. The measurement samples may pertain and/or be representable in frequency domain, and/or may include the typical frequency.

Analyzing the machine arrangement and/or operation of the machine arrangement may pertain to a specific component of the machine arrangement, in particular one with movable and/or vibrating and/or rotating part/s, e.g., a rotor and/or motor and/or generator and/or actuator. The speed or frequency of operation may pertain to a specific operational parameter of the machine arrangement and/or the component or its part, e.g., a rotational speed of the rotor of a motor or generator, and/or vibrational frequency of a machine. A machine arrangement may comprise a machine and/or motor; a motor may drive a machine. A machine may comprise a robot arm and/or manufacturing or processing device and/or pump. Frequency analysis may in some cases be performed pertaining to a component, like a motor and/or a machine.

An actual frequency f_{actual} (n) may be a frequency of the analyzed machine arrangement, and/or of its operation. It may be a frequency measured and/or determined during operation of the machine arrangement and/or pertaining to the component to be analyzed. The actual frequency may be associated to the timing T(n) and/or T_{adapt}(n) in that it may be representative of the frequency at and/or close to this time/these times. In some cases, it may be measured coincident in time domain with the obtained time domain sample T (n) . To each sample and/or sampling interval, there may be associated an actual frequency, which may differ between samples and/or sampling intervals. The actual frequency may be based on measurement and/or interpolation and/or estimation. Measurement may in particular be based on a current and/or an inverter or inverter current and/or optical and/or acoustic and/or force-based measurements of a moving and/or rotational component of a machine arrangement.

The method may especially be carried out, completely or in part, by electronic execution means like a computer system. To these ends, the method may be formulated as a computer program product with program code means. The above described system or arrangement may comprise the computer system. Advantages or features of the method may apply to the method and vice versa.

### Brief Summary of the Enclosed Figures

The above-described properties, features and advantages of present invention as well as the way they are achieved will be made clearer and better understandable in the light of the following discussion, making reference to exemplary embodiments shown in accompanying figures, in which
- Figure 1: shows an exemplary machine arrangement with current based analysis;
- Figure 2: shows another exemplary machine arrangement with faded spectral features in case of speed change;
- Figure 3: shows a desired frequency spectrum in case of speed change;
- Figure 4: shows a flow diagram of a method according to the invention;
- Figure 5: shows an exemplary diagram of obtained time domain measurement samples;
- Figure 6: shows an exemplary diagram of updated time domain samples;
- Figure 7: shows an exemplary diagram of normalized time domain samples;
- Figure 8: shows an exemplary diagram of a case of speed change during operation;
- Figure 9: shows an exemplary diagram of frequency analysis performed based on the data of Figure 8; and
- Figure 10: shows an exemplary diagram of frequency analysis performed based on the data of Figure 8 according to the invention.

### Detailed Exemplary Embodiments of the Invention

In the Figures, analysis of a machine arrangement comprising a motor driven by a current is described by way of example. Other ways parameters than current for frequency analysis may be considered. In general, the frequency of the peaks appearing in frequency spectrum and potentially indicating different errors may be proportional to the rotating frequency. In Motor Current Signature Analysis (based on current supplied to a motor), the approaches may be used as well, e.g. , if the motor is synchronous, or an induction motor; the changing of slip may be considered negligible. In the examples, a typical or reference frequency F of 50Hz is used. For different applications, a different reference frequency may be used, depending on use case, machine arrangement and/or operational conditions.

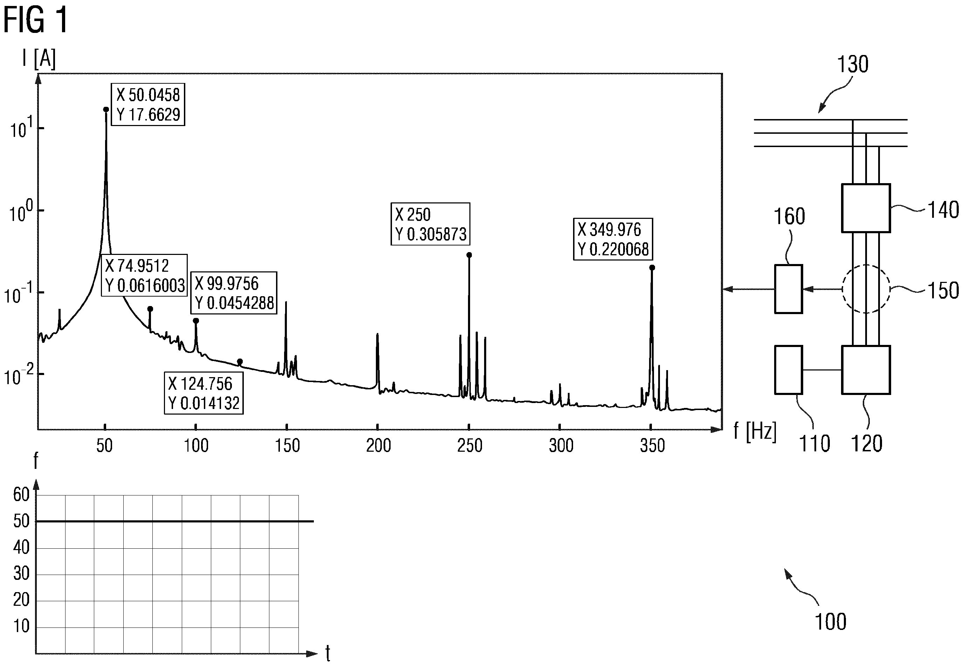

Figure 1 shows an exemplary machine arrangement 100, e.g., according to the invention. The machine arrangement 100 comprises a machine 110, which is driven by a motor 120, which may be AC driven. The motor 120 is provided with current via a three-phase current supply 130. The current is supplied by the current supply 130 to a current control device 140, which may be a synchronization device or inverter, depending on the motor type. From the device 140, current is provided to the motor 120. A sensor arrangement 150 provides measurement samples of the current amplitude/s to an electronic control device 160, which performs analysis of operation of the machine arrangement 100, represented by the motor 120. The analysis provided is seen as current (I) over frequency (f) spectrum.

At constant speed of around 50Hz (as can be seen in the diagram at the left lower corner showing frequency f over time t), a clear maximum peak appears at 50Hz in the frequency domain representation after FFT. Several other, smaller peaks can be seen, which may indicate potential error sources. The frequency of the peaks may be assumed to be proportional to the speed of a synchronous motor, and, e.g., if the change of slip is negligible, of an induction motor. These peaks may refer to specific errors. If an inverter 140 drives the motor 120 with constant speed, the Motor Current Signature Analysis can be used in the same manner, provided the supply frequency does not change.

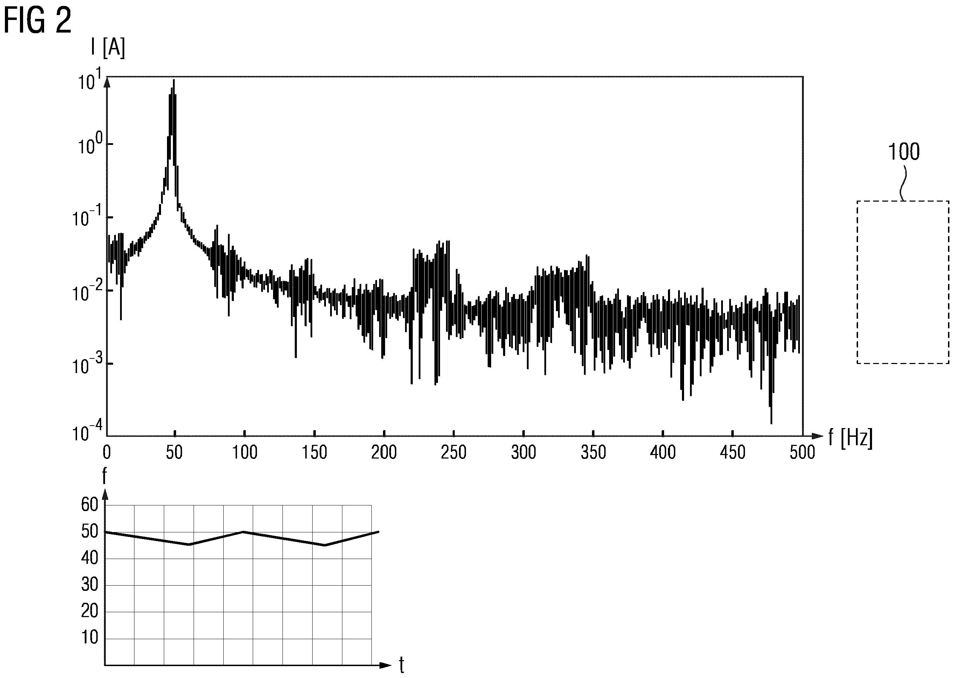

Figure 2 shows an example with the same machine arrangement 100 (only indicated by reference number), with a motor 120 operated at varying speeds, as indicated by the changing frequency in the diagram f-over-t in the lower left corner. If the device 140, e.g., an inverter, drives the motor 120 with varying speed, one of the following may occur:
when using long measuring times to achieve good resolution, peaks fade, and cannot be used efficiently for error analysis (as shown in Figure 2); when using short measurement times at almost constant speed, bad resolution may result, which may also lead to insufficient or unusable frequency analysis.

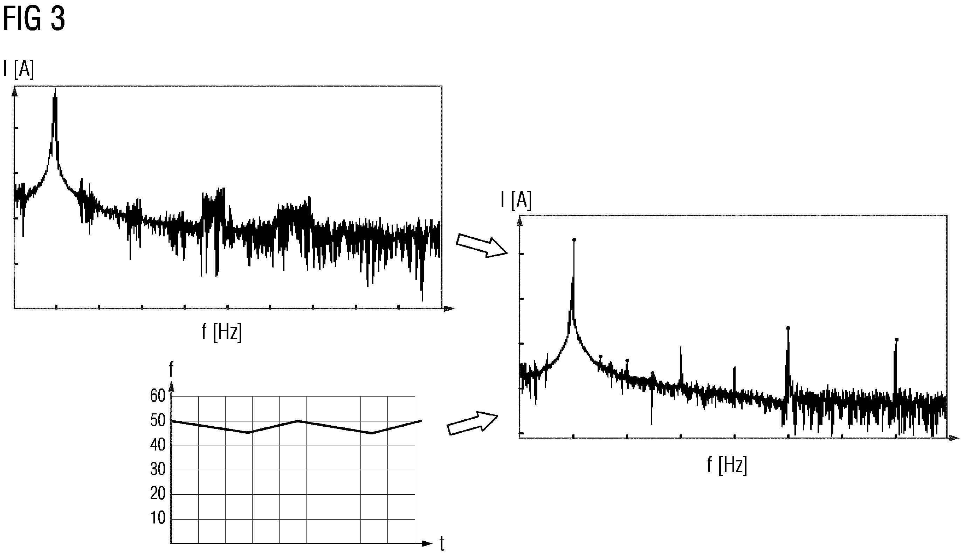

It is proposed to provide a frequency spectrum similar to the spectrum received at reference frequency (here 50Hz) with fixed speed. This is shown in Figure 3, with a frequency spectrum for varying speed with unclear peaks being transformed to a spectrum with clearly identified peaks, with what may be referred to as "50Hz normalized frequency spectrum".

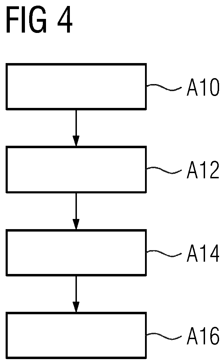

Figure 4 shows an exemplary flow diagram according to the invention. The method of analyzing a machine arrangement 100 comprises an action A10 of obtaining N time domain measurement samples (also referred to as original samples or originally obtained samples) at times T(n) pertaining to operation of the machine arrangement, with a typical frequency F of the operating machine arrangement. n is an integer or zero, which runs over the number of samples N, such that all N samples and/or gaps between samples may be referenced. For example, n may run from 0, 1, 2,... to N-1 (m may be analogous with reference to M). It may be considered that in general, each sample represents a position in time domain and a parameter value (in at least one other dimension, e.g., if scalar or representing a vector). The distance (duration or length of the time domain interval) between neighboring samples in time domain is T.

The method comprises an action A12 of determining updated time domain measurement samples (also referred to as updated samples) based on adapting a timing T_{adapt} (n) of each sample based on the associated T(n) and/or T, further based on an actual frequency factual(n) of the analyzed machine arrangement (100) associated to the timing T(n) and/or T_{adapt}(n), and further based on F. Thus, T (n) may be mapped to T_{adapt}(n)for each n. In particular, it may hold T_{adapt}(n)=T*f_{actual}(n)/F, or T_{adapt}(n)=f(T(n))*f_{actual}(n)/F. This may produce a spectrum similar to a constant speed spectrum by changing the time basis. A timing may generally indicate a position in time domain and/or a time interval duration, e.g., between two time domain positions of samples, which may be neighboring. f(T(n)) may represent a function of T(n), e.g., T(n)-T(n-1), or similar, for cases in which T(n) represent a time domain location of sample n.

Moreover, the method comprises an action A14 of determining M normalized time domain measurement samples at times T (m) with a constant sampling period T2, wherein m runs over the number of samples M. M may in particular be larger than N, and/or T2 may be shorter than a sampling period T based on which the samples originally are obtained. It should be noted that T2 may be considered an adapted and/or manufactured and/or virtual sampling period T2, which may be basis for an input for frequency analysis, which may require evenly-space samples in time domain.

The normalized samples may have values (in their other dimension/s than time) determined based on interpolation based on the sample values of the updated and/or originally obtained samples. The normalized time domain measurement samples may be shifted in time domain relative to the originally obtained samples, and shifted in their values (in the other dimension/s) . It may be considered that one or more of the original samples are not included in the normalized time domain measurement samples.

In an action A16, frequency analysis is performed on, and/or based on, the M normalized time domain measurement samples.

In general, the machine arrangement may be controlled to operate a varying and/or changing speed, e.g., due to operational conditions, and/or to scan a frequency range for hard-to-detect effects. For example, a machine arrangement like a pump may be controlled to operate at different frequencies in an operational range, which may in analysis may provide information (e.g., a peak) at a frequency that would not appear during operation at a typical frequency. In an exemplary scenario, a pump may have a resonance, e.g., at a lower edge of 35Hz in an operational range between 30Hz and 50Hz, or 30Hz and 70Hz; a typical frequency (operation at constant speed) may be 50Hz.

While operation at constant speed, the resonance may not be visible when performing frequency analysis; when controlling the pump (machine arrangement) at different speeds/frequencies, e.g., scanning or sampling the speed/frequency range, e.g., the operational range, it may be identifiable. This may be performed in relatively short timescales (without necessity to have a phase of near-constant speed per speed value), as the method described facilitates peak detection even for changing speeds with good reliability. A short timescale may be such that during a frequency analysis time window (e.g., a time for which one FFT is performed) the window covers multiple speeds and/or operation frequencies, and/or at least 10% or at least 25% or at least 50% of the operational range (in speed and/or frequency) and/or a speed change (e.g., maximum change or average change or minimum change within the time window) of at least 10% or at least 25% or at least 50%).

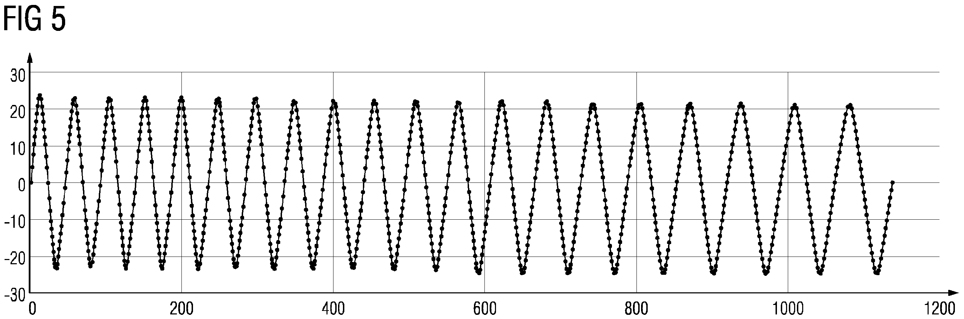

In more detail, Figure 5 shows an exemplary diagram of obtained time domain measurement samples. The axes show current amplitude (as indication of operation speed) over sample number in time. The samples are evenly spaced in time domain. As can be seen, the speed decreases in the example; peaks to the right are farther apart than peaks on the left. In the example, there is shown the time domain current measurement with 20 periods, speed decreasing.

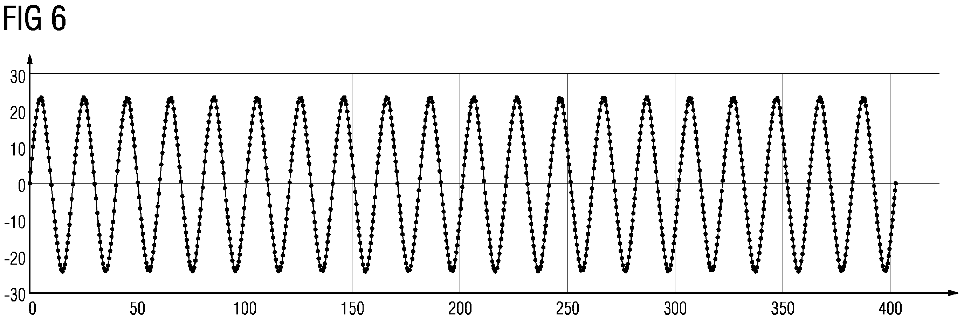

Figure 6 shows an exemplary diagram after determining upgraded samples. Each duration between neighboring samples has been adapted according to T_{adapt}=T*f_{actual}(n)/F (with F=50Hz; T may indicate the duration between two samples, e.g., between sample n-1 and n (or analogous, depending on the parametrisation of n used; n may run over the number of gaps). T may be constant for samples measured periodically, f_{actual} (n) may indicate the actual frequency at the new timing, or the old timing, or in a (e.g., small or close) environment thereof (e.g., 1/10 or smaller than the gap between samples in time domain).

Next to the current measurement, the actual frequency may be measured, for example the inverter may provide the exact actual frequency. In particular, it is proposed changing and/or adapting the length of all time intervals between the measuring points/samples; in an alternative expression, the formula: *T_{Norm}*=*T_{Sample}*∗*f_{actual}*/50*Hz* may be used, with T_{Norm} being another expression for T_{adapt}, and representing the length of a time interval between two samples after adaption; and *T_{Sample}* corresponding to T.

Accordingly, there is provided a signal which may be seen as a normed 50Hz current signal; since the sampling time is not constant, it cannot be directly subjected to an FFT. As an alternative expression, the adaption may be written as T_{adapt}(n)=T(n)*f_{actual}(n)/F, with T(n) representing potentially non-constant time domain gap between samples. The point of time of each sample may be determined based on adding the preceding T_{adapt} values (representing time durations) from the starting point (e.g., earliest T(n)).

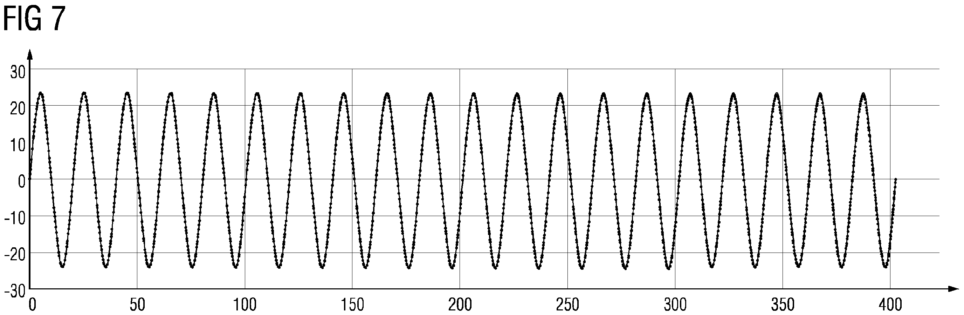

As shown in Figure 7, normalized time domain samples are determined. In the example, linear interpolation is used to create the normalized curve with more measuring points (samples), corresponding to smaller sampling time. The time between samples (sampling time) is constant. Instead of N samples, M samples are provided. Interpolation or Estimation is used to provide sample values at the newly determined points in time; instead of linear interpolation, other interpolation methods may be used; this may be decided based on balancing computational effort with quality of the interpolation and/or estimate. This provides data on which FFT can be used. The result can be used for diagnostic purposes and/or for controlling the machine arrangement. Peaks may be identifiable like with constant speed measurement, frequency resolution may be high.

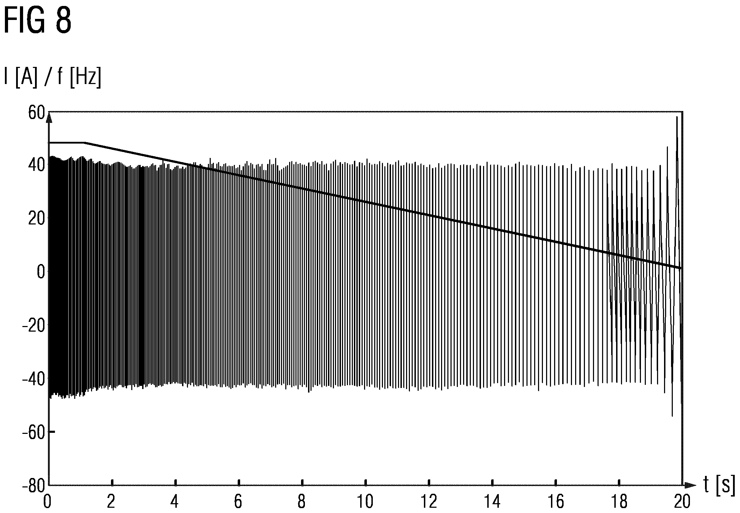

Figure 8 shows an example of a machine arrangement spectrum and frequency, where the speed (frequency) of operation decrease, as indicated by the prominent decreasing line.

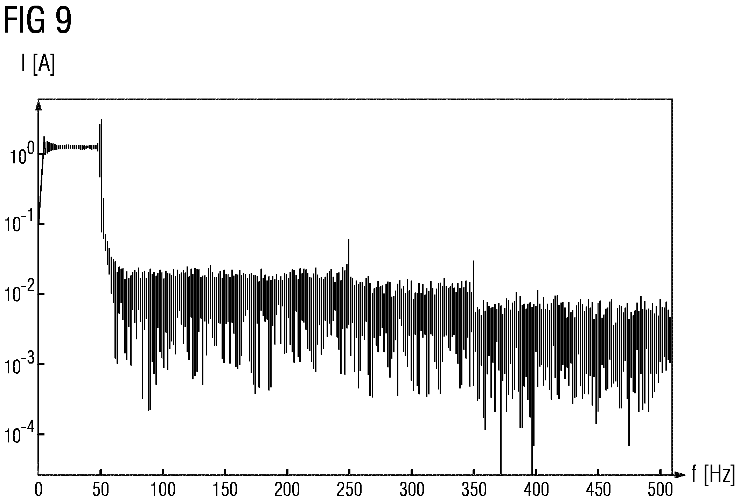

Figure 9 shows the current frequency spectrum of the situation shown in Figure 8 produced with an FFT using the samples originally provided. The peaks are faded/spread out significantly, which makes diagnosis and/or control difficult.

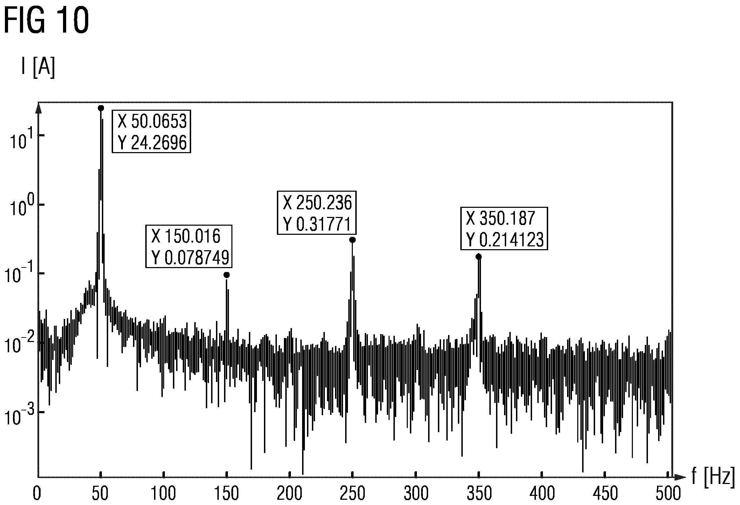

Figure 10 shows an example of using the inventive method on the original data of Figure 8, and performing FFT on the normalized samples. Peaks are prominent and easily identifiable.

In general, circuitry may comprise integrated circuitry. Processing circuitry may comprise one or more processors and/or controllers (e.g., microcontrollers), and/or ASICs (Application Specific Integrated Circuitry) and/or FPGAs (Field Programmable Gate Array), or similar. It may be considered that processing circuitry comprises, and/or is (operatively) connected or connectable to one or more memories or memory arrangements or storage media, which may be non-transitory. A storage medium or memory arrangement may comprise one or more memories. A memory may be adapted to store digital information. Examples for memories comprise volatile and non-volatile and/or non-transitory memory, and/or Random Access Memory (RAM), and/or Read-Only-Memory (ROM), and/or magnetic and/or optical memory, and/or flash memory, and/or hard disk memory, and/or EPROM or EEPROM (Erasable Programmable ROM or Electrically Erasable Programmable ROM).

Even though present invention has been illustrated and explained in detail above with reference to the preferred embodiments, the invention is not to be construed as limited to the given examples. Variants or alternate combinations of features given in different embodiments may be derived by a subject matter expert without exceeding the scope of present invention.

Independent of the grammatical term usage, individuals with male, female or other gender identities are included within the term.

### Reference List

- 100: machine arrangement
- 110: machine
- 120: motor
- 130: current supply
- 140: current control device
- 150: sensor arrangement
- 160: electronic control device

## Claims

1. Method of analyzing a machine arrangement (100), the method comprising:
- obtaining (A10) N time domain measurement samples at times T (n) pertaining to operation of the machine arrangement, with a typical frequency F of the operating machine arrangement, wherein n runs over the number of samples N, and the distance between neighboring samples in time domain is T;
- determining (A12) updated time domain measurement samples with timing T_{adapt}(n) of each sample based on the associated T (n) and/or T, further based on an actual frequency f_{actual}(n) of the analyzed machine arrangement (100) associated to the timing T (n) and/or T_{adapt}(n), and further based on F;
- determining (A14) M normalized time domain measurement samples at times T(m) with a constant sampling period T2, wherein m runs over the number of samples M;
- performing (A16) frequency analysis on the normalized time domain measurement samples.

2. Method according to claim 1, wherein the updated time domain measurement samples are determined based on T_{adapt}=T*f_{actual}(n)/F.

3. Method according to one of the preceding claims, wherein F lies in an operational range of frequencies of the machine arrangement (100).

4. Method according to one of the preceding claims, wherein F is 50Hz.

5. Method according to one of the preceding claims, wherein the samples indicate a current and/or voltage and/or speed and/or vibrational amplitude.

6. Method according to one of the preceding claims, wherein M>N.

7. Method according to one of the preceding claims, wherein the method is performed conditional on an acceleration threshold or speed change threshold being reached by the machine arrangement (100).

8. Method according to one of the preceding claims, wherein the machine arrangement (100) operates at varying speed.

9. Method according to one of the preceding claims, wherein the machine arrangement comprises a rotational element like a rotor or motor or generator.

10. Method according to one of the preceding claims, wherein the machine arrangement comprises an AC machine, and/or is driven by three-phase current, wherein the samples may represent a current amplitude.

11. Method according to one of the preceding claims, wherein performing frequency analysis comprises performing Fast Fourier Transform of the normalized time domain measurement samples.

12. Computer program product comprising program code causing processing circuitry and/or a computer to perform the method according to one of claims 1 to 11 when executed thereon.

13. Storage medium storing a computer program product according to claim 12.

14. Electronic control device comprising processing circuitry, the electronic control device being adapted to perform a method according to one of claims 1 to 11.

15. Machine arrangement comprising an electronic control device according to claim 14.
